Europäisches Patentamt

European Patent Office

Office européen des brevets

(11) Numéro de publication: **0 357 475 B1**

# FASCICULE DE BREVET EUROPEEN

(45) Date de publication de fascicule du brevet: **20.04.94**  (51) Int. Cl.5: **G01R 23/17**, G02F 2/00

(21) Numéro de dépôt: **89402016.3**

(22) Date de dépôt: **13.07.89**

(54) **Systèmes de mesure électrooptiques pour l'analyse fréquentielle de signaux à trés large bande.**

(30) Priorité: **19.07.88 FR 8809735**

(43) Date de publication de la demande:
**07.03.90 Bulletin 90/10**

(45) Mention de la délivrance du brevet:
**20.04.94 Bulletin 94/16**

(84) Etats contractants désignés:
**DE GB**

(56) Documents cités:
**US-A- 4 695 790**

**JAPANESE JOURNAL OF APPLIED PHYSICS/PART 1: REGULAR PAPERS & SHORT NOTES, no. 6, 26 juin 1987, pages 936-940, Tokyo, JP; T. HIKITA et al.: "A versatile spectrometer by the use of a pressure-scanned fabry-perot interferometer and a piezoelectrically-scanned fabry-perot interferometer in tandem arrangement"**

**IEEE JOURNAL OF OUANTUM ELECTRONICS, vol. OE-22, no. 1, 1 janvier 1986, pages 69-78, IEEE, New York, US; J.A. VALDMANIS et al.: "Subpicosecond electrooptic sampling: Principles and applications"**

**PATENT ABSTRACTS OF JAPAN, vol. 7, no. 234 (P-230)[1379], 18 octobre 1983, page 69 P 230; & JP-A-58 122 464 (FUJITSU K.K.) 21-07-1983**

(73) Titulaire: **FRANCE TELECOM**
**6, Place d'Alleray**
**F-75015 Paris(FR)**

(72) Inventeur: **Loualiche, Slimane**
**rue Park Moan**
**F-22300 Lannion(FR)**
Inventeur: **Salin, François**
**175, Boulevard Lefebvre**
**F-75015 Paris(FR)**

(74) Mandataire: **Cabinet Martinet & Lapoux**
**BP 405**
**F-78055 Saint Ouentin en Yvelines Cédex (FR)**

EP 0 357 475 B1

## Description

La présente invention concerne de manière générale la mesure de signaux électriques à très large bande de fréquence. Plus particulièrement, l'invention concerne la mesure des caractéristiques fréquentielles de signaux électriques à très large bande de fréquence par un procédé de mesure électro-optique.

J.A. VALDMANIS et G. MOUROU ont développé récemment un procédé pour mesurer la forme d'onde d'un signal électrique à très large bande par échantillonnage électro-optique. Ce procédé de mesure permet d'atteindre des résolutions temporelles de l'ordre de la picoseconde. Dans l'article intitulé "Subpicosecond Electrooptic Sampling : Principles and Applications" et paru dans IEEE JOURNAL OF QUANTUM ELECTRONICS, VOL. QE-22, N° 1, JANUARY 1986, J.A. VALDMANIS et G. MOUROU décrivent la configuration générale d'un système de mesure à échantillonnage électro-optique.

Ce procédé de mesure par échantillonnage électro-optique exploite l'existence de la biréfringence dans certains cristaux ayant une propriété électro-optique. Lorsqu'une onde lumineuse polarisée rectilignement rencontre une onde électrique produite par un signal électrique dans un cristal biréfringent, elle subit une rotation de polarisation due à l'interaction avec l'onde électrique. En se plaçant dans des conditions géométriques particulières, l'interaction entre les deux ondes induit dans l'onde lumineuse un retard de phase. L'onde lumineuse observée en polarisation croisée présente alors une intensité modulée par le signal électrique et il suffit de mesurer les variations d'intensité de l'onde lumineuse à l'aide d'un détecteur optique pour remonter au signal électrique. Pour obtenir une très bonne résolution temporelle on utilise une onde lumineuse formée d'un train d'impulsions de très faible largeur afin d'échantillonner le signal électrique. En retardant le train d'impulsions par rapport au signal électrique, il est possible d'explorer l'évolution temporelle du signal électrique. Le procédé s'apparente à de la stroboscopie pour des signaux répétitifs. La mesure de l'intensité de l'onde lumineuse s'effectue à très basse fréquence et donc avec un détecteur optique conventionnel à très faible bruit et très performant.

Un système de mesure à échantillonnage électro-optique est supérieur en résolution temporelle aux systèmes de mesure traditionnels de type purement électronique tels que l'oscilloscope à échantillonnage. Cette supériorité est due essentiellement au fait que la rotation de polarisation de l'onde lumineuse dans le cristal électro-optique est un phénomène instantané qui ne présente pas de constante de temps mesurable et consécutivement la résolution temporelle d'un tel système n'est essentiellement limitée que par la largeur des impulsions d'échantillonnage de l'onde lumineuse.

Un inconvénient de ces premiers systèmes de mesure à échantillonnage électro-optique réside toutefois dans le fait qu'il est nécessaire d'utiliser une source laser à émission impulsionnelle délivrant des impulsions lumineuses de très faible largeur, inférieure à la picoseconde. En effet, une source laser de ce type a généralement une longueur de plusieurs mètres et est donc très encombrante. De plus, elle est difficile à régler et est d'un prix relativement élevé. Un autre inconvénient important de ce système de mesure est qu'il n'est possible de mesurer que des signaux dont les fréquences de répétition sont des multiples entiers de la fréquence de répétition des impulsions lumineuses délivrées par la source laser. En conclusion, ces deux inconvénients conduisent à ce que ces premiers systèmes de mesure à échantillonnage électro-optique restent des systèmes expérimentaux difficiles à industrialiser et à commercialiser.

Dans des seconds systèmes de mesure à "échantillonnage" également décrits dans l'article précité de VALDMANIS et MOUROU, page 74, paragraphe V, la source laser impulsionnelle est remplacée par une source continue, telle qu'un laser hélium-néon, et le détecteur optique "lent" est remplacé par une caméra à balayage ultra-rapide. La caméra reçoit directement l'onde lumineuse modulée en amplitude émise par l'analyseur de sortie du modulateur électro-optique. Le système est "apparenté" à un oscilloscope standard, mais le rôle de l'amplificateur vertical et des plaques de déflexion est remplacé par le modulateur électro-optique ultra-rapide, et au lieu de la modulation de la position verticale d'un faisceau d'électrons, son intensité est modulée. En d'autres termes, un générateur sinusoïdal ayant une fréquence (85 MHz) nettement inférieure à la bande de fréquence du signal électrique à analyser découpe le signal à analyser et synchronise le balayage de la caméra, afin que le faisceau laser continu soit répétitivement modulé par le signal électrique à analyser en une onde lumineuse modulée périodiquement qui est détectée en synchronisme par la caméra.

Comme avec les premiers systèmes, les seconds systèmes de mesure explorent périodiquement l'évolution temporelle d'un signal électrique à analyser, et n'indiquent pas des caractéristiques du spectre fréquentiel du signal à analyser.

Le brevet US-A-4 695 790 décrit un analyseur de spectre comprenant une source laser continue, un modulateur électro-optique et plusieurs ensembles à filtre passe-bande optique et détecteur optique reliés à la sortie du modulateur électro-optique à travers un coupleur en étoile. Un signal électrique RF à analyser module l'onde optique produite par la source laser à travers le modulateur électro-optique. Des signaux électriques filtrés produits à des sorties des détecteurs optiques sont appliqués à un processeur qui traite en parallèle les signaux électriques filtrés pour produire le spectre du signal électrique à analyser.

L'invention vise à produire non pas le spectre d'un signal électrique mais une représentation générale des caractéristiques du spectre et notamment la largeur de bande et les fréquences limites haute et basse de ce spectre. Pour cela, l'invention ne met pas en oeuvre des moyens de traitement électronique complexes, tels qu'une batterie de filtres-détecteurs optiques selon le brevet américain précité, mais des dispositifs électriques et optiques connus combinés de manière judicieuse. Un système électro-optique selon l'invention présente l'avantage, comparativement à l'analyseur décrit dans le brevet américain, de pouvoir analyser des signaux électriques à fréquences très élevées car l'essentiel de l'analyse du signal est réalisé par des moyens optiques. De plus, le système selon l'invention offre des performances temporelles au moins équivalentes à celles des systèmes de mesure à échantillonnage électro-optique mais ne présentant pas leurs inconvénients mentionnés ci-dessus.

A cette fin, un système électro-optique selon l'invention pour l'analyse fréquentielle d'un signal électrique, est tel que défini par la revendication 1.

D'autres modes de réalisation du système selon l'invention sont énoncés dans les revendications 2 à 6.

L' invention sera mieux comprise à la lecture de la description suivante de plusieurs réalisations préférées d'un système de mesure électro-optique selon l'invention en référence aux dessins annexés correspondants dans lesquels :

- la Fig. 1 est un bloc-diagramme général d'un système de mesure électro-optique selon l'invention réalisé sous la forme d'un analyseur de spectre,
- la Fig. 2 montre la courbe de réponse d'un modulateur électro-optique à effet de POCKELS inclus dans le système de mesure électro-optique représenté à la Fig. 1,
- la Fig. 3 montre le spectre de fréquence d'une onde lumineuse modulée en amplitude par le modulateur électro-optique en fonction d'un signal électrique à analyser,
- la Fig. 4 montre schématiquement une réalisation particulière du modulateur électro-optique pour l'analyse in situ et sans contact de signaux électriques produits dans un micro-circuit ou un composant électronique réalisé sur un substrat cristallin ayant une propriété électro-optique, et

- la Fig. 5 montre schématiquement une autre réalisation particulière du modulateur électro-optique comprenant une sonde de mesure en cristal électro-optique pour l'analyse in situ et sans connexion de signaux électriques.

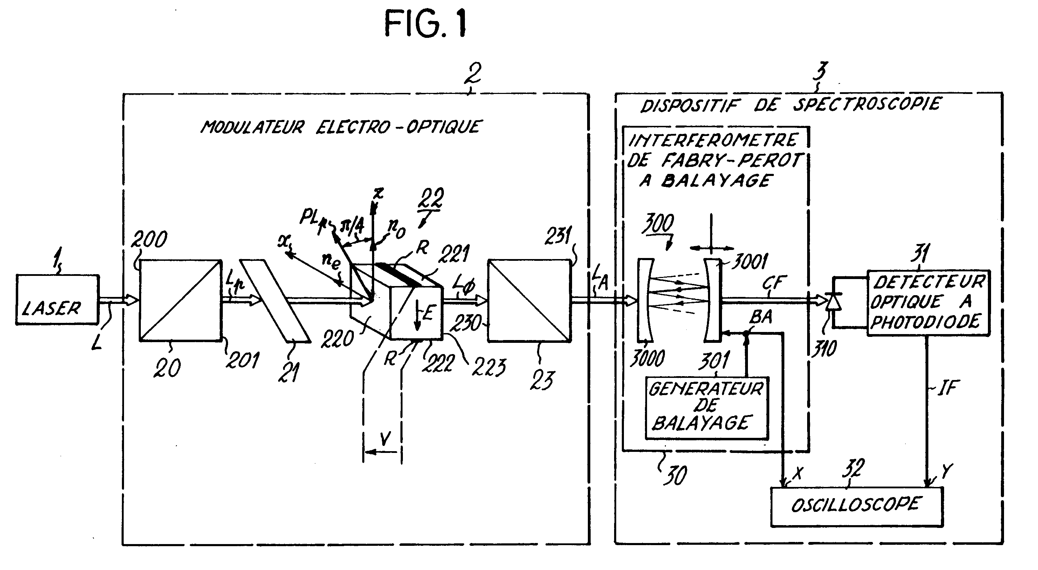

En référence à la Fig. 1, l'analyseur de spectre électro-optique selon l'invention comprend une source laser 1, un modulateur électro-optique 2, et un dispositif de spectroscopie 3.

La source laser 1 est de type monochromatique à émission continue et à très faible largeur de raie. La source laser 1 est par exemple constituée d'une source laser à gaz de type Hélium-Néon (He-Ne), stabilisée en fréquence et émettant une onde lumineuse L de longueur d'onde $\lambda_0$, de fréquence $f_0$ et de très faible largeur de raie .

Le modulateur électro-optique 2 est une cellule de POCKELS comprenant un polariseur 20, un compensateur 21, un cristal 22 ayant une propriété électro-optique, et un polariseur-analyseur 23.

Le polariseur 20 est par exemple constitué d'un prisme de GLAN ou de NICOLL. Il reçoit l'onde lumineuse L fournie par la source laser 1 à une première face 200 et délivre une onde lumineuse polarisée rectilignement $L_p$ par une seconde face 201. L'onde lumineuse $L_p$ est appliquée à travers le compensateur 21 à une première face 220 du cristal 22.

Le compensateur 21 est du type quart d'onde $\lambda_0/4$ et a pour fonction d'introduire un retard de phase $\Gamma_0 = \pi/2$ dans l'onde lumineuse $L_p$ afin de polariser le modulateur 2 dans une partie linéaire de sa courbe de réponse comme cela apparaîtra plus clairement par la suite dans la description.

Le cristal électro-optique 22 est par exemple constitué d'un cristal d'ADP $((NH_4)H_2PO_4)$ de forme parallélépipédique. Le cristal 22 comprend des axes cristallographiques perpendiculaires x et z auxquels correspondent respectivement des indices de réfraction extraordinaire $n_e$ et ordinaire $n_o$. La première face 220 du cristal 22 est parallèle au plan défini par les axes cristallographiques x et z. Des seconde et troisième faces parallèles 221 et 222 du cristal 22 perpendiculaires à la première face 220 comprennent des rubans conducteur R entre lesquels est appliqué un signal électrique à analyser V.

Le signal électrique V produit dans le cristal 22 un champ électrique transversal E perpendiculaire à la direction de propagation de l'onde lumineuse $L_p$ et parallèle à l'axe cristallographique z du cristal 22. L'onde lumineuse $L_p$ subit un retard de phase $\Delta\Gamma$ pendant la traversée du cristal 22. Le retard de phase $\Delta\Gamma$ est fonction du signal électrique V dont les variations d'amplitude introduisent dans le cristal 22 des modifications de sa propriété de biréfringence, c'est-à-dire des variations des indices de réfraction $n_o$ et $n_e$ dont la différence $n_o-n_e$ est

sensiblement proportionnelle au signal électrique V.

Le retard de phase $\Delta\Gamma$ introduit dans l'onde lumineuse $L_p$ pendant sa traversée du cristal 22 est exprimé par l'égalité :

$$\Delta\Gamma = \pi.(V/V_\pi),$$

où $V_\pi$ est un paramètre caractéristique du cristal 22 et de la longueur d'onde $\lambda_0$ de l'onde lumineuse $L_p$ ; le paramètre $V_\pi$ est de l'ordre du kilovolt.

Une onde lumineuse $L_\phi$ modulée en phase en fonction du signal électrique V est produite par le cristal 22. L'onde lumineuse $L_\phi$ est fournie par une quatrième face 223 du cristal 22, et est appliquée à une première face 230 du polariseur-analyseur 23.

Le polariseur-analyseur 23 est de type analogue au polariseur 20. Il est orienté de manière croisée par rapport au polariseur 20 et comprend donc une direction à $\pi/2$ de la direction du polariseur 20. Par une seconde face 231 parallèle à la première face 230, le polariseur 23 fournit une onde lumineuse $L_A$ en polarisation rectiligne croisée par rapport à l'onde lumineuse $L_p$. L'onde lumineuse $L_A$ présente une modulation en amplitude fonction du signal électrique V.

De préférence, afin d'obtenir une modulation d'amplitude maximale de l'onde lumineuse $L_A$, avec un indice de modulation égal à 1, et d'assurer ainsi une sensibilité de mesure maximale, l'onde lumineuse $L_p$ a un plan de polarisation $PL_p$ orienté, comme montré à la Fig. 1, à $\pi/4$ par rapport aux axes cristallographiques x et z du cristal 22, ce qui est obtenu au moyen d'une orientation convenable du polariseur 20 par rapport au cristal 22. Dans ces conditions, l'intensité $IL_A$ de l'onde lumineuse $L_A$ est exprimée par l'égalité suivante :

$$IL_A = IL_0.\sin^2((\Gamma_0 + \Delta\Gamma)/2) = (IL_0/2)(1-\cos(\Gamma_0 + \Delta\Gamma)),$$

où $IL_0$ est l'amplitude maximale de l'intensité $IL_A$.

Le retard de phase $\Gamma_0$ introduit par le compensateur 21 étant égal à $\pi/2$, l'intensité $IL_A$ de l'onde lumineuse $L_A$ en fonction du signal électrique V s'exprime par :

$$IL_A = (IL_0/2).(1 + \sin(\pi.V/V_\pi)).$$

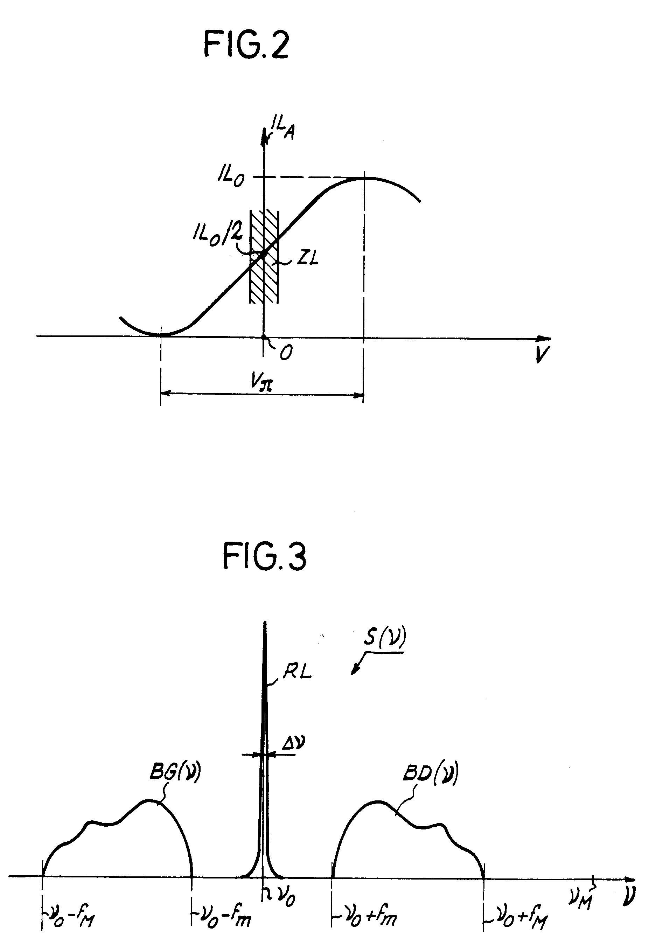

Cette dernière relation est illustrée par la courbe de réponse du modulateur électro-optique 2 montrée à la Fig. 2.

L'amplitude du signal électrique V est généralement très faible par rapport à la valeur du paramètre $V_\pi$ de l'ordre du kilovolt, de sorte que le rapport $V/V_\pi$ est très faible et le modulateur 2 fonctionne dans une zone de linéarité ZL. Dans la zone de linéarité ZL, l'intensité $IL_A$ en fonction du signal V est exprimée par l'égalité :

$$IL_A \cong (IL_0/2).(1 + \pi.V/V_\pi).$$

En référence à la Fig. 3, l'onde lumineuse $L_A$ modulée linéairement en amplitude par le signal électrique V a un spectre de fréquence $S(\nu)$ comprenant une raie de fréquence RL à la fréquence $\nu_0$ correspondant à l'onde lumineuse émise par la source laser 1 et deux bandes latérales $BD(\nu)$ et $BG(\nu)$ dues à la modulation d'amplitude de l'onde $L_A$ et correspondant au spectre de fréquence $B(f)$ du signal électrique V.

Les bandes latérales $BG(\nu)$ et $BD(\nu)$ comprennent des fréquences limites basses et hautes respectivement égales à $\nu_0$-$f_M$ et $\nu_0$-$f_m$, et $\nu_0 + f_m$ et $\nu_0 + f_M$, où $f_m$ et $f_M$ sont respectivement les fréquences limites basse et haute du spectre de fréquence $B(f)$ du signal V. Les bandes latérales $BG(\nu)$ et $BD(\nu)$ sont liées au spectre de fréquence $B(f)$ par les égalités :

$$BG(\nu) = B(\nu_0\text{-}f), \text{ et}$$

$$BD(\nu) = B(\nu_0 + f).$$

L'onde lumineuse $L_A$ porte donc toute l'information relative au signal électrique V à analyser et il est aisé connaissant le spectre de fréquence de l'onde lumineuse $L_A$ d'en déduire le spectre de fréquence $B(f)$ du signal V.

En référence à la Fig. 1, le dispositif de spectroscopie 3 a pour fonction d'analyser en fréquence le spectre de l'onde lumineuse $L_A$ afin de déterminer le spectre $B(f)$ du signal électrique V.

Le dispositif de spectroscopie 3 est par exemple constitué d'un interféromètre de FABRY-PEROT à balayage 30, d'un détecteur optique à photodiode 31, et d'un oscilloscope 32.

L'interféromètre de FABRY-PEROT à balayage est un dispositif bien connu de l'homme du métier et son fonctionnement ne sera pas ici décrit en détail. Il comprend essentiellement une cavité accordable 300 et un générateur de balayage 301. L'onde lumineuse $L_A$ est injectée dans la cavité 300 à travers une première paroi semi-transparente 3000. Une seconde paroi semi-transparente 3001 de la cavité 300 est équipée d'un dispositif de commande piézoélectrique et est mobile en position par rapport à la première paroi 3000. Le déplacement de la paroi 3001 est commandé par un signal de rampe de balayage BA à basse fréquence. Sous la commande du signal de rampe BA, la cavité 300 est successivement accordée à différentes fréquences d'un domaine de fréquence à explorer et délivre des composantes lumineuses fréquentielles correspondantes CF à travers la seconde paroi 3001.

Une photodiode 310 du détecteur optique 31 reçoit les composantes lumineuses fréquentielles CF fournies par la cavité 300 et délivre en réponse un courant représentatif de l'intensité desdites composantes. A partir du courant délivré par la photodiode 310, le détecteur 31 produit un signal d'intensité IF représentant l'intensité des différentes composantes fréquentielles CF dans le domaine de fréquence exploré.

Le signal de rampe de balayage BA et le signal d'intensité IF sont appliqués respectivement à des entrées X et Y de l'oscilloscope 32 afin de visualiser le spectre de fréquence S($\nu$) sur l'écran cathodique de l'oscilloscope 32.

De préférence, la cavité 300 est choisie afin de présenter un intervalle fréquentiel libre compris entre la fréquence $\nu_0$ et une fréquence maximale $\nu_M$ - (Fig. 3) dans lequel est comprise la bande latérale BD($\nu$) du spectre de fréquence S($\nu$). Cet interface temporel libre est balayé sous la commande du signal de rampe BA et, la raie de fréquence $\nu_0$ étant prise comme origine de fréquence f = 0 Hz, une représentation uniquement du spectre de fréquence B(f) est ainsi obtenue sur l'écran de l'oscilloscope 32.

L'analyseur de spectre électro-optique selon l'invention peut être employé afin de caractériser des composants électroniques et des microcircuits hyperfréquences sur substrat semiconducteur. Ainsi par exemple dans le cas où le substrat du microcircuit est constitué d'un cristal ayant une propriété électro-optique tel que l'arséniure de gallium (AsGa), il est alors possible d'analyser des signaux électriques in situ, sans nécessité de contact ni de connexion par fils en se servant de la propriété électro-optique du substrat pour moduler l'onde lumineuse.

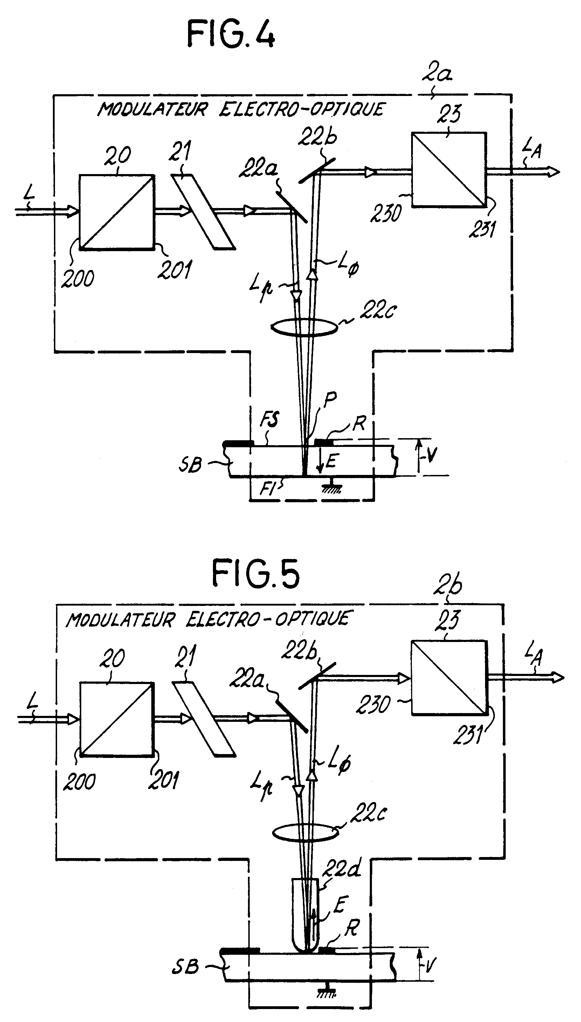

En référence à la Fig. 4, un modulateur électro-optique 2a pour une analyse in situ d'un signal électrique V dans un microcircuit réalisé sur un substrat cristallin électro-optique SB comprend un polariseur 20, un compensateur 21, deux miroirs analogues 22a et 22b, une lentille convergente 22c, et un polariseur-analyseur 23.

Les polariseur 20, compensateur 21 et polariseur-analyseur 23 sont analogues à ceux compris dans le modulateur 2 montré à la Fig. 1 et ont les mêmes fonctions. Dans le modulateur 2a, le cristal électro-optique 22 (Fig. 1) est supprimé et la modulation en phase de l'onde lumineuse polarisée $L_p$ est réalisée directement dans le substrat cristallin électro-optique SB.

L'onde lumineuse $L_p$ polarisée rectilignement et sortant du compensateur 21 est orientée par le miroir 22a vers un point P au voisinage d'un ruban conducteur R localisé sur une face supérieure FS du substrat SB. Le ruban conducteur R convoie le signal électrique à analyser V. L'onde lumineuse $L_p$ est appliquée au point P du substrat SB à travers la lentille convergente 22c.

La lentille convergente 22c a pour fonction de diminuer la résolution spatiale de la mesure en focalisant l'onde lumineuse $L_p$ sur le point P qui diminue en surface et peut ainsi être rapproché du ruban conducteur R.

L'onde lumineuse $L_p$ est dirigée vers le point P avec un angle d'incidence sensiblement inférieur à $\pi/2$ et se propage dans le substrat SB jusqu'à une face inférieure métallisée FI portée à une tension de référence. Au niveau de la face inférieure FI, l'onde lumineuse $L_p$ est rétroréfléchie vers la face supérieure FS. L'onde lumineuse sortant du substrat SB par la face supérieure FS est modulée en phase et forme l'onde lumineuse $L_\phi$. Dans le substrat SB, le signal électrique V produit un champ électrique E sensiblement longitudinal aux directions de propagation des ondes lumineuses incidente et réfléchie. Par effet électro-optique, les ondes lumineuses se propageant dans le substrat SB subissent un retard de phase fonction du signal électrique V.

L'onde lumineuse $L_\phi$ sortant du substrat SB traverse la lentille convergente 22c et est dirigée par le miroir 22b vers la première face 230 du polariseur-analyseur 23. Par la seconde face 231, le polariseur-analyseur 23 délivre l'onde lumineuse $L_A$ polarisée rectilignement et modulée en amplitude par le signal électrique V.

Dans le cas où le substrat SB supportant le microcircuit à caractériser n'a pas de propriété électro-optique, un modulateur électro-optique 2b, montré à la Fig. 5, comprenant une sonde de mesure 22d en cristal électro-optique peut être utilisé. La sonde 22d est alors placée à proximité du ruban conducteur R convoyant le signal électrique V afin que la sonde 22d soit traversée par des lignes du champ électrique E produit par le signal V. Il est ainsi possible d'analyser le signal électrique V sans aucune connexion entre le ruban conducteur R et le modulateur électro-optique 2b.

L'invention peut donner lieu à de multiples réalisations autres que celles décrites en référence aux Figs. 1 à 5.

Ainsi, concernant le dispositif de spectroscopie 3 inclus dans l'analyseur et décrit en référence à la Fig. 1, d'autres types d'interféromètres à balayage sont utilisables. Une représentation sur oscilloscope du spectre du signal à analyser n'est pas toujours désirée. Dans ce cas le dispositif de spectroscopie est par exemple constitué d'un spectrographe à élément dispersif délivrant un enregistrement du spectre sur un support papier.

De plus, lorsqu'une connaissance précise du spectre n'est pas nécessaire et qu'il est désiré connaître par exemple la fréquence fondamentale du signal, l'invention peut prendre la forme d'un fréquencemètre et comprendre par exemple un interféromètre de MICHELSON réglé manuellement jusqu'à délivrance par le détecteur optique à photodiode 31 d'une réponse maximale indiquant que l'interféromètre est accordé à la fréquence fondamentale. Une lecture sur un curseur gradué de l'interféromètre indique alors la valeur recherchée de la fréquence fondamentale du signal.

Les performances d'un analyseur de spectre électro-optique selon l'invention sont essentiellement limitées par les performances de l'interféromètre inclus dans le dispositif de spectroscopie et par la stabilité et la largeur de raie de l'onde lumineuse produite par la source laser. Une réalisation particulière d'un analyseur de spectre selon l'invention constitué à partir d'un interféromètre de FABRY-PEROT et d'une source laser disponibles dans le commerce atteint les performances suivantes dans le cas d'une mesure in situ sans contact :

- bande passante de quelques kilohertz à 8000 GHz,
- sensibilité inférieure à 1 mV,
- résolution spectrale sensiblement égale à 1 kHz, et
- résolution spatiale de quelques micromètres.

## Revendications

1. Système électro-optique pour l'analyse fréquentielle d'un signal électrique (V) dans lequel sont prévus

des moyens (1) pour produire et émettre en continu une première onde lumineuse cohérente monochromatique (L) d'intensité constante,

des moyens de modulation (2) pour moduler linéairement en amplitude ou en phase la première onde lumineuse (L) par le signal électrique à analyser (V) afin de produire une seconde onde lumineuse modulée ($L_A$), et

des moyens de spectroscopie (3) comprenant des moyens accordables de mesure de fréquence (30) pour recevoir la seconde onde lumineuse ($L_A$) et délivrer en réponse l'une de composantes lumineuses fréquentielles (CF) de la seconde onde lumineuse ($L_A$) ayant une fréquence égale à une fréquence sur laquelle sont accordés lesdits moyens accordables de mesure de fréquence (30), des moyens de détection (31) pour détecter l'intensité desdites composantes lumineuses fréquentielles, et des moyens de visualisation pour visualiser (32) un signal d'intensité (IF) produit par lesdits moyens de détection (31) et représentatif d'une intensité de ladite une de composantes lumineuses fréquentielles (CF),

caractérisé en ce que

lesdits moyens de spectroscopie (3) comprennent des moyens (301) pour générer un signal de balayage de fréquence (BA) qui respectivement accorde et commande en balayage lesdits moyens accordables de mesure de fréquence (30) et lesdits moyens de visualisation (32) successivement sur différentes fréquences du domaine de fréquence à explorer, afin que lesdits moyens accordables de mesure de fréquence (30) délivrent successivement lesdites composantes fréquentielles pour visualiser sur lesdits moyens de visualisation commandés en balayage (32) un spectre de fréquence de ladite seconde onde lumineuse ($L_A$) dans ledit domaine de fréquence à explorer pour en déduire des caractéristiques fréquentielles (B(f)) du signal électrique à analyser (V).

2. Système conforme à la revendication 1, caractérisé en ce que les moyens de spectroscopie (3) comprennent un interféromètre de FABRY-PEROT à balayage.

3. Système conforme à l'une quelconque des revendications 1 à 2, caractérisé en ce que les moyens pour produire et émettre (1) comprennent une source laser à émission continue stabilisée en fréquence et à faible largeur de raie.

4. Système conforme à l'une quelconque des revendications 1 à 3, caractérisé en ce que les moyens de modulation (2) comprennent un cristal électro-optique (22) ayant en surface des rubans conducteurs (R) entre lesquels est appliqué le signal électrique (V) et recevant la première onde lumineuse ($L_p$), préalablement polarisée, afin de produire une troisième onde lumineuse ($L_\phi$) modulée en phase par le signal électrique à analyser (V) à partir de laquelle un polariseur-analyseur (23) fournit la seconde onde lumineuse ($L_A$) modulée par le signal électrique à analyser (V).

5. Système conforme à la revendication 4, caractérisé en ce que ledit cristal électro-optique est constitué par le substrat cristallin (2a, SB) d'un microcircuit ou un composant électronique à caractériser dans lequel est établi un champ électrique (E) induit par le signal électrique à analyser (V).

6. Système conforme à l'une quelconque des revendications 1 à 3, caractérisé en ce que les moyens de modulation (2b) comprennent une sonde de mesure en cristal électro-optique (22d) soumise à un champ électrique (E) induit par le signal électrique à analyser (V) et recevant la première onde lumineuse ($L_p$), préalablement polarisée, afin de produire une troisiè-

me onde lumineuse ($L_\phi$) modulée en phase par le signal électrique à analyser (V) à partir de laquelle un polariseur-analyseur (23) fournit la seconde onde lumineuse ($L_A$) modulée par le signal électrique à analyser (V), le champ électrique (E) dans ladite sonde (22d) étant induit par rapprochement de la sonde à un conducteur (R) convoyant le signal électrique à analyser (V).

**Claims**

1. Electrooptic system for frequential analysis of an electrical signal (V) in which are provided
   means (1) for continuously producing and emitting a first monochromatic coherent light wave (L) with a constant intensity,
   modulation means (2) for linearly amplitude or phase modulating the first light wave (L) by the electrical signal to be analyzed (V) thereby producing a second modulated light wave ($L_A$), and
   spectroscopy means (3) comprising tunable frequency-measurement means (30) for receiving the second light wave ($L_A$) and deriving in response one of frequential light components (CF) of the second light wave ($L_A$) having a frequency equal to a frequency to which said tunable frequency-measurement means (30) are tuned, detection means (31) for detecting the intensity of said frequency light components, and display means (32) for displaying an intensity signal (IF) produced by said detection means (31) and representative of an intensity of said one of the frequential light components (CF),
   characterized in that
   said spectroscopy means (3) comprise means (301) for generating a frequency sweep signal (BA) which respectively tunes and sweep-controls said tunable frequency-measurement means (30) and said display means (32) successively for different frequencies within the frequency range to be scanned, whereby said tunable frequency-measurement means (30) successively provide said frequency components to display on said sweep-controlled display means (32) a frequency spectrum of said second light wave ($L_A$) within said frequency range to be scanned for deducting frequential characteristics (B(f)) of the electrical signal to be analyzed (V).

2. System according to claim 1, characterized in that the spectroscopy means (3) comprise a sweep FABRY-PEROT interferometer.

3. System according to any one of claims 1 to 2, characterized in that the producing and emitting means (1) comprise a continuous emission laser source with stabilized frequency and small line width.

4. System according to any one of claims 1 to 3, characterized in that the modulation means (2) comprise an electrooptic crystal (22) having ribbon conductors (R) on its surface between which is applied the electrical signal (V) and receiving the first light wave ($L_P$) which has previously been polarized thereby deriving a third light wave ($L_\phi$) phase modulated by the electrical signal to be analyzed (V) from which a polarizer-analyzer (23) supplies the second light wave ($L_A$) modulated by the electrical signal to be analyzed (V).

5. System according to claim 4, characterized in that said electrooptic crystal is comprised of the crystalline substrate (2a, SB) of a microcircuit or of an electrical component to be characterized in which an electric field (E) induced by the electrical signal to be analyzed (V) is derived.

6. System according to any one of claims 1 to 3, characterized in that the modulation means (2b) comprise an measurement probe made of electrooptic crystal (22d) subjected to an electric field (E) induced by the electrical signal to be analyzed (V) and receiving the first light wave ($L_P$) which has previously been polarized thereby deriving a third light wave ($L_\phi$) phase modulated by the electrical signal to be analyzed (V) from which a polarizer-analyzer (23) supplies the second light wave ($L_A$) modulated by the electric signal to be analyzed (V), the electric field (E) in said probe (22d) being induced by bringing the probe near a conductor (R) carrying the electrical signal to be analyzed (V).

**Patentansprüche**

1. Elektro-optisches System zur Frequenzanalyse eines elektrischen Signals (V), in welchem vorgesehen sind
   Mittel (1) zum Erzeugen und kontinuierlichen Abgeben einer ersten kohärenten monochromatischen Lichtwelle (L) konstanter Intensität,
   Modulationsmittel (2) zum linearen Amplituden- oder Phasenmodulieren der ersten Lichtwelle (L) durch das zu analysierende elektrische Signal (V), um eine zweite modulierte Lichtwelle ($L_A$) zu erzeugen, und

Spektroskopiemittel (3), die abstimmbare Frequenzmeßmittel (30) zum Empfang der zweiten Lichtquelle ($L_A$) und, als Antwort, zur Ausgabe einer der Frequenzlichtkomponenten (CF) der zweiten Lichtwelle ($L_A$), die eine Frequenz hat, die gleich derjenigen Frequenz ist, auf welche die abstimmbaren Frequenzmeßmittel (30) abgestimmt sind, Feststellmittel (31) zur Feststellung der Intensität der Frequenzlichtkomponenten, und Visualisationsmittel zum Sichtbarmachen (32) eines Intensitätssignals (IF) aufweisen, das von den Feststellmitteln (31) erzeugt ist und eine Intensität der einen der Frequenzlichtkomponenten (CF) repräsentiert,
dadurch gekennzeichnet, daß
die Spektroskopiemittel (3) Mittel (301) zur Erzeugung eines Frequenzabtastsignals (BA) aufweisen, welche die abstimmbaren Frequenzmeßmittel (30) sowie die Visualisationsmittel (32) nacheinander auf die verschiedenen Frequenzen des zu untersuchenden Frequenzbereichs abstimmen und ins Abtasten steuern, damit die abstimmbaren Frequenzmeßmittel (30) nacheinander die Frequenzkomponenten abgeben, um auf den ins Abtasten gesteuerten Visualisationsmitteln (32) ein Frequenzspektrum der zweiten Lichtwelle ($L_A$) in dem zu untersuchenden Frequenzbereich anzuzeigen, um daraus die Frequenzcharakteristik (B(f)) des zu analysierenden elektrischen Signals (V) abzuleiten.

2. System nach Anspruch 1, dadurch gekennzeichnet, daß die Spektroskopiemittel (3) ein FABRY-PEROT Interferometer zum Abtasten aufweisen.

3. System nach einem der Ansprüche 1 bis 2, dadurch gekennzeichnet, daß die Mittel (1) zum Erzeugen und Abgeben eine Laserquelle kontinuierlicher Emission umfassen, die frequenzstabilisiert ist und kleine Linienbreite hat.

4. System nach einem der Ansprüche 1 bis 3, dadurch gekennzeichnet, daß die Modulationsmittel (2) einen elektro-optischen Kristall (22) aufweisen, der eine Oberfläche von Leiterstreifen (R) hat, zwischen welchen das elektrische Signal (V) aufgegeben wird, und der die erste, vorzugsweise polarisierte Lichtquelle ($L_p$) aufnimmt, um eine dritte Lichtquelle ($L_\phi$) zu erzeugen, die von dem zu untersuchenden elektrischen Signal (V) phasenmoduliert ist, von welcher ausgehend ein Polarisator/Analysator (23) die zweite Lichtquelle ($L_A$) ausgehend liefert, die von dem zu untersuchenden elektrischen Signal (V) moduliert ist.

5. System nach Anspruch 4, dadurch gekennzeichnet, daß der elektro-optische Kristall durch das kristalline Substrat (2a, SB) einer Mikroschaltung oder ein zu charakterisierendes elektronisches Bauteil gebildet ist, in welchem ein elektrisches Feld (E) durch das zu untersuchende elektrische Signal (V) erzeugt ist.

6. System nach einem der Ansprüche 1 bis 3, dadurch gekennzeichnet, daß die Modulationsmittel (2b) eine Meßsonde aus einem elektro-optischen Kristall (22d) umfaßt, die einem elektrischen, von dem zu untersuchenden elektrischen Signal (V) induzierten Feld (E) unterworfen ist und die erste vorzugsweise polarisierte Lichtquelle ($L_p$) empfängt, um eine dritte Lichtquelle ($L_\phi$) zu erzeugen, die durch das zu untersuchende elektrische Signal (V) phasenmoduliert ist, von welcher ausgehend ein Polarisator/Analysator (23) die zweite, von dem elektrischen zu untersuchenden Signal (V) modulierte Lichtquelle ($L_A$) liefert, wobei das elektrische Feld (E) in der Sonde (22d) durch Annähern der Sonde an einen das zu untersuchende elektrische Signal (V) führenden Leiter induziert wird.

FIG.1

EP 0 357 475 B1

# FIG.2

# FIG.3

EP 0 357 475 B1

# FIG.4

MODULATEUR ELECTRO-OPTIQUE

# FIG.5

MODULATEUR ELECTRO-OPTIQUE

11